# EUROPÄISCHE PATENTSCHRIFT

(11) **EP 1 152 527 B1**
(45) Veröffentlichungstag und Bekanntmachung des Hinweises auf die Patenterteilung: **29.10.2008**
(21) Anmeldenummer: 01108779.8
(22) Anmeldetag: 06.04.2001
(51) Int. Cl.: H03G 3/32

(54) **Vorrichtung und Verfahren zum geräuschabhängigen Anpassen eines akustischen Nutzsignals**
Device and method for adaption of an acoustic signal depending on the ambient noise
Dispositif et procédé pour l'adaptation d'un signal acoustique en fonction du niveau de bruit ambiant

(30) Priorität: 27.04.2000 DE 10020756
(43) Veröffentlichungstag der Anmeldung: 07.11.2001
(73) Patentinhaber: Harman Becker Automotive Systems GmbH, 76307 Karlsbad (DE)
(72) Erfinder: Azizi, Seved Ali, 72800 Eningen (DE)
(74) Vertreter: Patentanwälte Westphal, Mussgnug & Partner

(56) Entgegenhaltungen:
- EP-A- 0 319 777
- US-A- 5 434 922
- US-A- 5 450 494
- US-A- 5 666 426

## Beschreibung

Die Erfindung betrifft eine Vorrichtung und ein Verfahren zum geräuschabhängigen Anpassen eines an einem Abhörort auftretenden akustischen Nutzsignals.

Wenn Musik oder Sprache in einer geräuscherfüllten Umgebung dargeboten wird, ist in der Regel der Hörgenuss durch das Hintergrundgeräusch getrübt. Ein lärmerfüllter Raum, an dem häufig Musik und Sprache abgehört wird, ist beispielsweise der Innenraum eines Kraftfahrzeuges. Das Hintergrundgeräusch kann dabei vom Motor, von den Reifen, von dem Gebläse und anderen Aggregaten in dem Kraftfahrzeug herrühren und daher von der Geschwindigkeit, den Straßenbedingungen und den Betriebszuständen im Kraftfahrzeug abhängen. Dieser zeitlich sich ändernden Geräuschkulisse wird ein Kraftfahrzeuginsasse dadurch begegnen, dass er die Lautstärke von in Form von Musik oder Sprache dargebotenen Nutzsignalen entsprechend durch Drehen am Lautstärkeregler anpasst.

Beispielsweise aus der US 5,434,922 ist ein Verfahren und eine Vorrichtung zur dynamischen Klangoptimierung bekannt, bei dem automatisch in Abhängigkeit vom Hintergrundgeräusch die Lautstärke des Nutzsignals eingestellt wird. Dabei wird unter Verwendung eines Mikrophons der Gesamtschall in dem Abhörraum ausgewertet derart, dass das dem Gesamtschall entsprechende Signal einem Extrahierer zugeführt wird, der aus dem Gesamtsignal den Geräuschsignalanteil extrahiert. Dieser extrahierte Geräuschsignalanteil wird in einer nachfolgenden Verstärkungsberechnungsstufe mit dem Originalsignal der Tonquelle verglichen. Das Ergebnis dieses Vergleichs dient dann zur Einstellung der Lautstärke des akustischen Nutzsignals.

Bei dem beispielsweise aus der EP 0 319 777 A2 bekannten Verfahren zur selbsttätigen störgeräuschabhängigen Lautstärkeregelung wird die Amplitude von Nutzsignalen, welche mindestens einem Lautsprecher zugeführt und in Nutzschall umgewandelt werden, geregelt und mit Hilfe mindestens eines Mikrofons, welches dem Nutzschall und Störgeräusch ausgesetzt ist, ein Summensignal erzeugt. Beim Summensignal wird zur Bildung eines Stellsignals für die Lautstärkeregelung ein weiteres Signal überlagert, das aus dem Nutzsignal mit Hilfe einer Nachbildung der Übertragungsstrecke wird ein adaptives Digitalfilter verwendet.

Problematisch ist bei diesen Vorrichtungen und den ihnen zugrundeliegenden Verfahren jedoch, dass das Extrahieren des Geräuschsignalanteils nicht vollständig gelingt, so dass im extrahierten Geräuschsignalanteil auch Anteile des Nutzsignals enthalten sind. Damit wird der gesamten Vorrichtung jedoch ein Geräuschpegel zugrundegelegt, der höher ist als der tatsächliche Geräuschpegel. Damit wird jedoch eine höhere Lautstärke eingestellt, was seinerseits die Wirkung hat, dass auch der im extrahierten Geräuschsignalanteil enthaltene Nutzsignalanteil sich erhöht, was wiederum zu einer Erhöhung des Lautstärkepegels führt. Dieser auch als "Gain Chase" bezeichnete Vorgang würde dabei beim maximal möglichen Lautstärkepegel enden, so dass der im Kraftfahrzeug befindliche Zuhörer wiederum manuell in das Geschehen eingreifen müsste.

Aufgabe der Erfindung ist es, eine Vorrichtung und ein Verfahren zum geräuschabhängigen Anpassen eines an einem Abhörort abgestrahlten akustischen Nutzsignals anzugeben, bei denen dieser Nachteil nicht auftritt.

Die Aufgabe wird durch eine Vorrichtung gemäß Patentanspruch 1 bzw. durch ein Verfahren gemäß Patentanspruch 7 gelöst.Ausgestaltung und Weiterbildung des Erfindergedankens sind Gegenstand von Unteransprüchen.

Die vorliegende Erfindung zeichnet sich insbesondere durch einen gegenüber bisherigen Lösungen äußerst geringen zusätzlichen Aufwand aus. Darüber hinaus ist bei der Erfindung prinzipbedingt sichergestellt, dass unter keinen Umständen ein selbsttätiges Hochfahren der Lautstärke auftritt.

Erreicht wird dies im Einzelnen durch eine Vorrichtung mit einer Tonquelle zum Erzeugen eines durch ein Steuersignal einstellbaren elektrischen Nutzsignals sowie mit einem der Tonquellen nachgeschalteten Schallwandler zum Erzeugen des akustischen Nutzsignals aus dem elektrischen Nutzsignal, wobei ein Schallaufnehmer zur Erzeugung eines elektrischen Abhörsignals aus dem akustischen Nutzsignal sowie aus einem akustischen Geräuschsignal am Abhörort vorgesehen ist. Dem Schallaufnehmer ist ein Extrahierer zum Extrahieren des im Abhörsignal enthaltenen Nutzsignalanteils nachgeschaltet. Ein eingangsseitig mit Schallaufnehmer und Extrahierer und ausgangsseitig mit der Tonquelle gekoppelte Steuereinrichtung steuert die Tonquelle in Abhängigkeit von dem Ergebnis eines Vergleichs des im Abhörsignal enthaltenen Nutzsignalanteils mit dem Abhörsignal selbst. Ist nun beispielsweise in dem extrahierten Nutzsignalanteil auch ein bestimmter Geräuschsignalanteil enthalten, dann führt dies dazu, dass die Lautstärke des akustischen Nutzsignal verringert wird, was dem zufolge zu einem geringeren Geräuschsignalanteil im extrahierten Nutzsignalanteil führt. Durch diese Abnahme des akustischen Nutzsignalpegels gegenüber dem Geräuschsignalpegel nimmt jedoch die Einflussnahme des Geräuschsignalpegels auf den Lautstärkepegel und damit die Genauigkeit der gesamten Vorrichtung zu. Schließlich wird sich die gesamte Vorrichtung auf einen stabilen Wert einpendeln.

Dies trifft auch zu auf ein erfindungsgemäßes Verfahren mit den Schritten: Erzeugen des akustischen Nutzsignals aus einem elektrischen Nutzsignal, Abnehmen eines von dem akustischen Nutzsignal und einem akustischen Geräuschsignal am Abhörort bestimmten elektrischen Abhörsignals, Extrahieren des in dem Abhörsignal enthaltenen Nutzsignalanteils, Vergleichen des in dem Abhörsignal enthaltenen Nutzsignalanteils mit dem Abhörsignal und Anpassen des elektrischen Nutzsignals in Abhängigkeit von dem Ergebnis des Vergleichsschrittes.

Des Weiteren wird bevorzugt sowohl bei der Vorrichtung als auch bei dem Verfahren die Extraktion mittels adaptiver Filterung durchgeführt, wobei aus dem elektrischen Abhörsignal unter Verwendung des an der Tonquelle abgenommenen elektrischen Nutzsignals der im Abhörsignal enthaltene Nutzsignalanteil extrahiert wird. Adaptive Filter haben den Vorteil, dass mit einem verhältnismäßig geringen Aufwand eine hohe Genauigkeit erzielt wird. Dabei wird bevorzugt zur adaptiven Filterung nach der Methode der kleinsten mittleren Fehlerquadrate (LMS = Least-Mean-Square-Verfahren) vorgegangen.

Zum Steuern der Lautstärke wird bei dem Verfahren und der Vorrichtung gemäß der Erfindung das Verhältnis von dem im Abhörsignal enthaltenen Nutzsignalanteil zu dem Abhörsignal selbst ausgewertet, wobei bevorzugt zur Verhältnisbildung vorgesehen ist, etwa durch Logarithmieren den Pegel des im Abhörsignal enthaltenen Nutzsignalanteils und dem Pegel des Abhörsignals zu bilden und beide Pegel voneinander zu subtrahieren. Dies entspricht einer Verhältnisbildung mit anschließender Logarithmierung, was beispielsweise zur Einstellung der Lautstärke zweckmäßiger sein kann. Die Bildung der beiden Pegel mit anschließender Subtrahierung hat dabei den Vorteil einer unaufwendigen Realisierung vor allem in digitaler Schaltungstechnik. Als Pegel kann zum Beispiel der Pegel der mittleren Absolutwerte oder aber bevorzugt der Leistungspegel verwendet werden.

Bevorzugt wird dabei die gesamte Vorrichtung zumindest teilweise in digitaler Schaltungstechnik ausgeführt oder das erfindungsgemäße Verfahren beispielsweise durch einen entsprechend programmierte digitale Signalverarbeitungseinrichtung (beispielsweise Signalprozessor) ausgeführt. Dabei sind elektrisches Nutzsignal und elektrisches Abhörsignal digitale Signale und/oder digitalisierte Signale mit bestimmter Abtastrate. Vorzugsweise wird dann die Extraktion und/oder der Vergleich bei verringerter Abtastrate durchgeführt. Durch diese Maßnahme kann der gesamte Rechenaufwand erheblich reduziert werden.

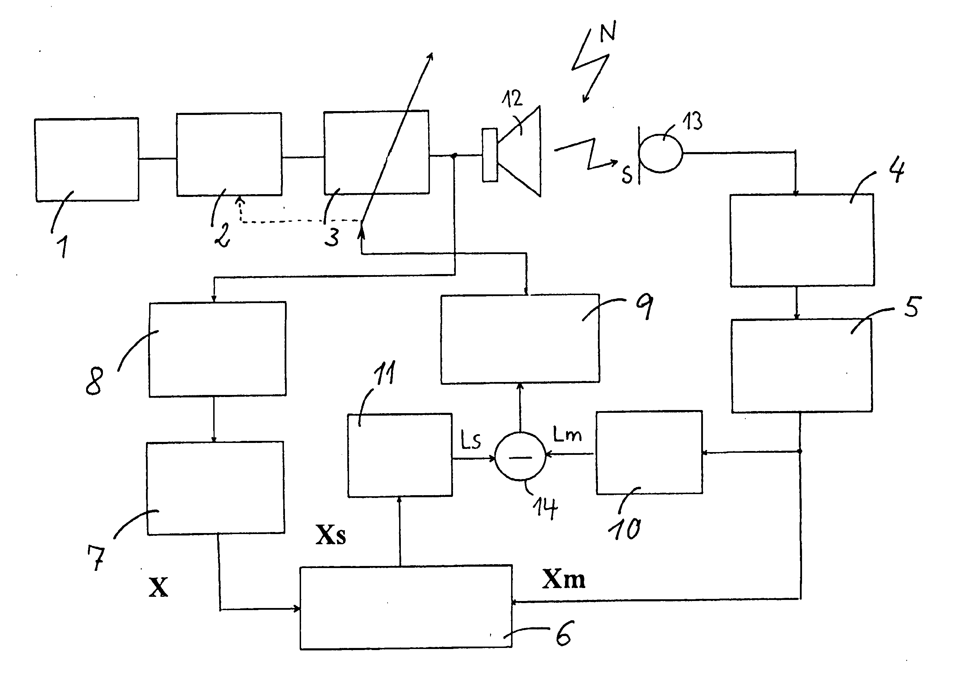

Die Erfindung wird nachfolgend anhand des in der einzigen Figur der Zeichnung dargestellten Ausführungsbeispiels näher erläutert.

Bei der in der Zeichnung gezeigten Ausführungsform ist eine Tonquelle vorgesehen, die eine elektrische Signalquelle 1, eine dieser nachgeschaltete Tonprozessoreinheit 2, einer dieser wiederum nachgeschaltete Lautstärkestelleinheit 3 sowie einer nachfolgende Aktivlautsprechereinheit 12 aufweist. Bei Anwendung in einem Kraftfahrzeug kommt als elektrische Signalquelle 1 vorzugsweise ein Kompakt-Disk-Abspielgerät, ein Radioempfangsteil, ein Kompakt-Kassetten-Abspielgerät, ein MP3-Abspielgerät oder ein sonstiges Tonträgerabspielgerät in Frage, wobei beim Ausführungsbeispiel die von der elektrischen Signalquelle 1 abgegebenen Signale bereits in digitaler Form vorliegen. Gegebenenfalls benötigte Analog-Digital-Umsetzer sind der Einfachheit halber in der Zeichnung nicht dargestellt.

Die an die elektrische Signalquelle 1 anschließende Tonprozessoreinheit 2 umfasst beispielsweise Klangregeleinrichtungen, Komprimiereinrichtungen, Rauschunterdrückungssysteme und ähnliches. Die Lautstärkestelleinheit 3 ist dabei derart aufgebaut, dass die Lautstärke durch zwei Steuersignale unabhängig voneinander einstellbar ist. Das eine Steuersignal wird dabei von einem externen Bedienelement erzeugt, das beispielsweise als ein von Fahrzeuginsassen einstellbarer Lautstärkeregler ausgebildet ist. Das andere Steuersignal dient zur Anpassung des Lautstärkepegels an das Umgebungsgeräusch. Dabei wird die Lautstärke automatisch so eingestellt, dass sich ein minimales Nutzsignal-zu Geräuschsignal-Verhältnis ergibt. Die Aktivlautsprechereinheit 12 umfasst neben entsprechenden Schallwandlern auch die zur Ansteuerung der Schallwandler notwendigen Endstufen sowie bei digitaler Ansteuerung Digital-Analog-Umsetzer.

Die Steuerung der Lautstärke und gegebenenfalls weiterer Größen wie beispielsweise Kompression und Frequenzgang erfolgt durch eine Einrichtung, an deren Anfang ein Mikrofon 13 als Schallaufnehmer für den beispielsweise im Kraftfahrzeuginnenraum vorhandenen Schall steht. Dieser Schall setzt sich zum einen aus dem von der Aktivlautsprechereinheit 12 abgestrahlten akustischen Nutzsignal S und dem zu dem als Hintergrundgeräusch auftretenden akustischen Geräuschsignal N zusammen. Das Mikrofonsignal wird beispielsweise verstärkt und mittels eines nicht gezeigten Analog-Digital-Umsetzers in ein entsprechendes digitales Signal umgewandelt, welches als elektrisches Abhörsignal Xm dient. Das Abhörsignal Xm wird einem adaptiven Filter 6 zugeführt, welches nach der Methode der kleinsten mittleren Fehlerquadrate (LMS) arbeitet und an das darüber hinaus das Tonquellensignal X am Ausgang der Lautstärkestelleinheit 3 angelegt wird. Das adaptive Filter 6 stellt sich dabei so ein, dass an seinem Ausgang der in dem Abhörsignal Xm enthaltene Nutzsignalanteil (Xs) extrahiert wird. Um den Aufwand für das adaptive Filter 6 sowie nachfolgender Einheit zu reduzieren, sind in die Signalzweige des Abhörsignals Xm und des Tonquellensignals X jeweils Abtastratenreduziereinrichtungen geschaltet, die im einfachsten Fall aus einem Bandbegrenzungsfilter 4 bzw. 8 sowie einem Decimator 5 bzw. 7 besteht.

Das adaptive Filter 6 kann unter Verwendung des LMS-Verfahrens entweder in rekursiver Struktur (IIR) oder nicht rekursiver Struktur (FIR) bei geeigneter Länge und Schrittweite ausgeführt sein. Es verwendet das in der Abtastrate reduzierte Tonquellensignal X und das in der Abtastrate reduzierte Abhörsignal Xm, um näherungsweise die geräuschfreie Nutzsignalkomponente, also das von der Aktivlautsprechereinheit 12 zum Mikrofon 13 übertragene akustische Nutzsignal S aus dem Abhörsignal Xm zu extrahieren und als extrahiertes Nutzsignal Xs auszugeben. Dies wird im wesentlichen dadurch erreicht, dass das adaptive Filter 6 den Signalpfad zwischen Aktivlautsprechereinheit 12 und Mikrofon 13 nachbildet.

Das Abhörsignal Xm und das extrahierte Nutzsignal Xs werden anschließend einem Vergleich unterzogen, bei dem vorzugsweise beide Signale zueinander ins Verhältnis gesetzt werden. Beim vorliegenden Ausführungsbeispiel erfolgt die Verhältnisbildung dadurch, dass von beiden Signalen Xs und Xm zunächst der jeweilige Leistungspegel Ls bzw. Lm gebildet wird und dann die beiden Pegel Ls und Lm voneinander abgezogen werden. Die Pegelbildung kann beispielsweise auch durch ein einfaches Filter mit geeigneter Zeitkonstante durchgeführt werden, wobei quadrierte Abtastwerte des extrahierten Nutzsignals Xs und des Abhörsignals (Xm) diesem Filter zugeführt werden. Nachfolgend werden das extrahierte Nutzsignal Xs und das Abhörsignal Xm jeweils einer Pegelstufe 11 bzw. 10 zugeführt, deren Ausgänge mittels eines Subtrahierers 14 die beiden Pegel voneinander abgezogen. An Stelle der Verwendung von Leistungspegeln wie beim Ausführungsbeispiel könnten aber in gleicher Weise auch die mittleren Amplitudenquadrate (Leistung) oder die mittleren Absolutwerte usw. miteinander verglichen werden.

Eine dem Subtrahierer 14 nachgeschaltete Verstärkungsberechnungseinheit 9 berechnet auf Basis des Subtraktionsergebnisses am Ausgang des Subtrahierers 14 die Verstärkungsabstufung, um sicherzustellen, daß die Differenz der Leistungen Lm-Ls welche mit dem Nutzsignalleistungs-/Geräuschleistungs-Verhältnis (in dB) korrespondiert, nach Ablauf einer bestimmten vorgegebenen Reaktionszeit unter einem minimalen Pegel ist. Die Verstärkung wird graduell angehoben, solange die Differenz größer ist als ein bestimmter vorgegebener Wert.

## Patentansprüche

1. Vorrichtung zum geräuschabhängigen Anpassen eines an einem Abhörort auftretenden akustischen Nutzsignals (S) mit
einer Tonquelle (1, 2, 3, 12) zum Erzeugen eines durch ein Steuersignal einstellbaren elektrischen Nutzsignals (X),
einem der Tonquelle (1, 2, 3) nachgeschalteten Schallwandler (12) zum Erzeugen des akustischen Nutzsignals (S) aus dem elektrischen Nutzsignal (X),
einem Schallaufnehmer (13) zur Erzeugung eines elektrischen Abhörsignals (Xm) aus dem akustischen Nutzsignal (S)
sowie aus einem akustischen Geräuschsignal (N) am Abhörort,
**gekennzeichnet durch**
einem dem Schallaufnehmer (13) nachgeschalteten Extrahierer (6) zum Extrahieren des im Abhörsignal (Xm) enthaltenen Nutzsignalanteils (Xs), und
einer eingangsseitig mit Schallaufnehmer (13) und Extrahierer (6) und ausgangsseitig mit der Tonquelle (1, 2, 3) gekoppelten Steuereinrichtung (9, 10, 11, 14) zum Steuern der Tonquelle (1, 2, 3) in Abhängigkeit von dem Ergebnis eines Vergleichs des im Abhörsignal (Xm) enthaltenen Nutzsignalanteils (Xs) mit dem Abhörsignal (Xm).

2. Vorrichtung nach Anspruch 1, bei der
der Extrahierer ein adaptives Filter (6) aufweist, das aus dem elektrischen Abhörsignal unter Verwendung des an der Tonquelle (1, 2, 3) abgenommenen elektrischen Nutzsignals (X) den im Abhörsignal (Xm) enthaltenen Nutzsignalanteil (Xs) extrahiert.

3. Vorrichtung nach Anspruch 2, bei der
das adaptive Filter (6) nach der Methode der kleinsten Fehlerquadrate arbeitet.

4. Vorrichtung nach einem der vorherigen Ansprüche, bei der
zum Vergleichen des im Abhörsignal (Xm) enthaltenen Nutzsignalanteils (Xs) mit dem Abhörsignal (Xm) beide zueinander ins Verhältnis gesetzt werden.

5. Vorrichtung nach Anspruch 4, bei der
zur Verhältnisbildung die Steuereinrichtung (9, 10, 11, 14) den Pegel des im Abhörsignal (Xm) enthaltenen Nutzsignalanteils (Xs) und den Pegel des Abhörsignals (Xm) bildet und beide Pegel (Ls, Lm) voneinander subtrahiert.

6. Vorrichtung nach einem der vorherigen Ansprüche, bei der
Extrahierer (6) und Steuereinrichtung (9, 10, 11, 14) Mittel zur Verarbeitung digitaler Signale aufweisen, wobei elektrisches Nutzsignal (X) und elektrisches Abhörsignal (Xm) digitale Signale und/oder digitalisierte Signale mit bestimmter Abtastrate sind, und
dem Extrahierer (6) und/oder der Steuereinrichtung (9, 10, 11, 14) Einrichtungen (4, 5, 7, 8) zur Abtastreduzierung vorgeschaltet sind.

7. Verfahren zum geräuschabhängigen Anpassen eines an einem Abhörort auftretenden akustischen Nutzsignals (S) mit den Schritten:
Erzeugen des akustischen Nutzsignals (S) aus einem elektrischen Nutzsignal (X),
Abnehmen eines von dem akustischen Nutzsignal (S) und einem akustischen Geräuschsignal (N) am Abhörort bestimmten elektrischen Abhörsignal,
**gekennzeichnet durch**
Extrahieren des in dem Abhörsignal enthaltenen Nutzsignalanteils (Xs),
Vergleichen des in dem Abhörsignal enthaltenen Nutzsignalanteils (Xs) mit dem Abhörsignal (Xm) und
Anpassen des elektrischen Nutzsignals (X) in Abhängigkeit von dem Ergebnis des Vergleichsschrittes.

8. Verfahren nach Anspruch 7, bei dem aus dem elektrischen Abhörsignal (Xm) unter Verwendung des elektrischen Nutzsignals (X) der im Abhörsignal (Xm) enthaltene Nutzsignalanteil (Xs) durch adaptive Filterung extrahiert wird.

9. Verfahren nach Anspruch 8, bei dem
die adaptive Filterung auf der Methode der kleinsten Fehlerquadrate beruht.

10. Verfahren nach einem der Ansprüche 7 bis 9, bei dem
der Vergleichsschritt eine Verhältnisbildung aus dem in dem Abhörsignal enthaltenen Nutzsignalanteil (Xs) und dem Abhörsignal (Xm) beinhaltet.

11. Verfahren nach Anspruch 10, bei dem
zur Verhältnisbildung vorgesehen ist, den Pegel (Ls) des im Abhörsignal enthaltenen Nutzsignalanteils (Xs) und dem Pegel (Lm) des Abhörsignals (Xm) zu bilden und beide Pegel (Ls, Lm) voneinander zu subtrahieren.

12. Verfahren nach einem der Ansprüche 7 bis 11, bei dem
elektrisches Nutzsignal (X) und elektrische Abhörsignal (Xm) digitale Signale und/oder digitalisierte Signale mit bestimmter Abtastrate sind und
der Extraktionsschritt und/oder der Vergleichsschritt bei demgegenüber verringerter Abtastrate durchgeführt wird.

## Claims

1. Apparatus for the noise-dependent adaptation of an acoustic useful signal (S) occurring in a listening location, with
- a sound source (1, 2, 3, 12) for generating an electrical useful signal (X) which can be adjusted by a control signal,
- an acoustic transducer (12) which is connected downstream of the sound source (1, 2, 3) for generating the acoustic useful signal (S) from the electrical useful signal (X),
- an acoustic receiver (13) for generating an electrical listening signal (Xm) from the acoustic useful signal (S) and also from an acoustic noise signal (N) at the listening location,
**characterised by**
- an extractor (6) connected downstream of the acoustic receiver (13) for extracting the useful signal component (Xs) contained in the listening signal (Xm), and
- a coupling device (9, 10, 11, 14) coupled on the input side to the acoustic receiver (13) and the extractor (6) and on the output side to the sound source (1, 2, 3) for controlling the sound source (1, 2, 3) as a function of the result of a comparison of the useful signal component (Xs) contained in the listening signal (Xm) with the listening signal (Xm) itself.

2. Apparatus as claimed in Claim 1, wherein the extractor has an adaptive filter (6) by which the useful signal component (Xs) contained in the listening signal is extracted from the electrical listening signal using the electrical useful signal (X) picked up at the sound source (1,2,3).

3. Apparatus as claimed in Claim 2, wherein the adaptive filter (6) operates according to the least squares method.

4. Apparatus as claimed in any one of the preceding claims, wherein for comparison of the useful signal component (Xs) contained in the listening signal (Xm) with the listening signal (Xm) itself a ratio is formed between them.

5. Apparatus as claimed in Claim 4, wherein for forming the ratio the control device (9, 10, 11, 14) forms the level of the useful signal component (Xs) contained in the listening signal (Xm) and the level of the listening signal (Xm) itself and subtracts both levels (Ls, Lm) from one another.

6. Apparatus as claimed in any one of the preceding claims, wherein the extractor (6) and the control device (9, 10, 11, 14) have means for processing digital signals, wherein the electrical useful signal (X) and the electrical listening signal (Xm) are digital signals and/or digitised signals with a specific sampling rate, and devices (4, 5, 7, 8) for reducing sampling are connected upstream of the extractor (6) and/or the control device (9, 10, 11, 14).

7. Method for noise-dependent adaptation of an acoustic useful signal (S) occurring at a listening location, with the steps:
- generation of the acoustic useful signal (S) from an electrical useful signal (X),
- picking up of an electrical listening signal determined at the listening location from the acoustic useful signal (S) and the acoustic noise signal (N),
**characterised by**
- extraction of the useful signal component (Xs) contained in the listening signal,
- comparison of the useful signal component (Xs) contained in the listening signal with the listening signal (Xm) itself, and
- adaptation of the electrical useful signal (X) as a function of the result of the comparison step.

8. Method as claimed in Claim 7, wherein the useful signal component (Xs) contained in the listening signal (Xm) is extracted from the electrical listening signal (Xm) by adaptive filtering using the electrical useful signal (X).

9. Method as claimed in Claim 8, wherein the adaptive filtering is based on the least squares method.

10. Method as claimed in any one of Claims 7 to 9, wherein the comparison step includes forming a ratio from the useful signal component (Xs) contained in the listening signal and the listening signal (Xm) itself.

11. Method as claimed in Claim 10, wherein for formation of this ratio the level (Ls) of the useful signal component (Xs) contained in the listening signal and the level (Lm) of the listening signal (Xm) are formed, and the two levels (Ls, Lm) are subtracted from one another.

12. Method as claimed in any one of Claims 7 to 11, wherein the electrical useful signal (X) and the electrical listening signal (Xm) are digital signals and/or digitised signals with a specific sampling rate and the extraction step and/or the comparison step are carried out at a comparatively reduced sampling rate.

## Revendications

1. Dispositif pour l'adaptation en fonction du bruit d'un signal acoustique utile (S) apparaissant sur un lieu d'écoute avec
une source sonore (1, 2, 3, 12) pour la génération d'un signal électrique utile (X) réglable au moyen d'un signal de commande,
un transducteur acoustique (12) monté en aval de la source sonore (1, 2, 3) pour la génération du signal acoustique utile (S) à partir du signal électrique utile (X),
un capteur acoustique (13) pour la génération d'un signal électrique d'écoute (Xm) à partir du signal acoustique utile (S) et à partir d'un signal acoustique de bruit (N) sur le lieu d'écoute,
**caractérisé par**
un extracteur (6) monté en aval du capteur acoustique (13) pour l'extraction de la portion du signal utile (Xs) contenue dans le signal d'écoute (Xm), et
un dispositif de commande (9, 10, 11, 14) couplé au capteur acoustique (13) et à l'extracteur (6) du côté entrée et à la source sonore (1, 2, 3) du côté sortie pour la commande de la source sonore (1, 2, 3) en fonction du résultat d'une comparaison entre la portion du signal utile (Xs) contenue dans le signal d'écoute (Xm) et le signal d'écoute (Xm).

2. Dispositif selon la revendication 1, dans lequel
l'extracteur comporte un filtre adaptatif (6) qui extrait du signal électrique d'écoute la portion du signal utile (Xs) contenue dans le signal d'écoute (Xm) en utilisant le signal électrique utile (X) prélevé à la source sonore (1, 2, 3).

3. Dispositif selon la revendication 2, dans lequel
le filtre adaptatif (6) fonctionne suivant la méthode des moindres carrés.

4. Dispositif selon l'une quelconque des revendications précédentes, dans lequel
pour la comparaison entre la portion du signal utile (Xs) contenue dans le signal d'écoute (Xm) et le signal d'écoute (Xm), les deux sont mis en rapport l'un avec l'autre.

5. Dispositif selon la revendication 4, dans lequel,
pour la réalisation du rapport, le dispositif de commande (9, 10, 11, 14) forme le niveau de la portion du signal utile (Xs) contenue dans le signal d'écoute (Xm) et le niveau du signal d'écoute (Xm) et soustrait les deux niveaux (Ls, Lm) l'un de l'autre.

6. Dispositif selon l'une quelconque des revendications précédentes, dans lequel
l'extracteur (6) et le dispositif de commande (9, 10, 11, 14) comportent des moyens pour le traitement de signaux numériques, le signal électrique utile (X) et le signal électrique d'écoute (Xm) étant des signaux numériques et/ou des signaux numérisés avec des vitesses de balayage déterminées et
des dispositifs (4, 5, 7, 8) étant montés en amont de l'extracteur (6) et/ou du dispositif de commande (9, 10, 11, 14) pour la réduction du balayage.

7. Procédé pour l'adaptation en fonction du bruit d'un signal acoustique utile (S) apparaissant sur un lieu d'écoute avec les étapes de :
génération du signal acoustique utile (S) à partir d'un signal électrique utile (X),
prélèvement d'un signal électrique d'écoute déterminé par le signal acoustique utile (S) et un signal acoustique de bruit (N) sur le lieu d'écoute,
**caractérisé par**
l'extraction de la portion du signal utile (Xs) contenue dans le signal d'écoute,
comparaison entre la portion du signal utile (Xs) contenue dans le signal d'écoute et le signal d'écoute (Xm) et
adaptation du signal électrique utile (X) en fonction du résultat de l'étape de comparaison.

8. Procédé selon la revendication 7, dans lequel la portion du signal utile (Xs) contenue dans le signal d'écoute (Xm) est extraite par filtrage adaptatif du signal électrique d'écoute (Xm) en utilisant le signal électrique utile (X).

9. Procédé selon la revendication 8, dans lequel
le filtrage adaptatif repose sur la méthode des moindres carrés.

10. Procédé selon l'une quelconque des revendications 7 à 9, dans lequel l'étape de comparaison comprend l'établissement d'un rapport à partir de la portion du signal utile (Xs) contenue dans le signal d'écoute et du signal d'écoute (Xm).

11. Procédé selon la revendication 10, dans lequel
pour la réalisation du rapport, il est prévu de former le niveau (Ls) de la portion du signal utile (Xs) contenue dans le signal d'écoute et le niveau (Lm) du signal d'écoute (Xm) et de soustraire les deux niveaux (Ls, Lm) l'un de l'autre.

12. Procédé selon l'une quelconque des revendications 7 à 11, dans lequel
le signal électrique utile (X) et le signal électrique d'écoute (Xm) sont des signaux numériques et/ou des signaux numérisés avec des vitesses de balayage déterminées et, par contre,
l'étape d'extraction et/ou l'étape de comparaison est réalisée à une vitesse de balayage réduite.
